# EUROPEAN PATENT APPLICATION

(11) **EP 4 711 934 A1**
(43) Date of publication of application: **18.03.2026**
(21) Application number: 25194578.8
(22) Date of filing: 07.08.2025
(51) Int. Cl.: G06F 11/3668, G06F 30/20, G06F 11/3698

(54) **OPERATIONAL DESIGN DRIVEN TESTING OF AND MANUFACTURING AN ELECTRONIC CONTROL UNIT**

(30) Priority: 13.09.2024 EP 24200196
(71) Applicant: Elektrobit Automotive GmbH, 91058 Erlangen (DE)
(72) Inventor: Kleinhenz, Thomas, 91058 Erlangen (DE); Zimmerer, Alexander, 91058 Erlangen (DE); Hofmann, Georg, 91058 Erlangen (DE); Strumberg, Olaf, 91058 Erlangen (DE)
(74) Representative: Aumovio Corporation

(57) **Abstract**

Embodiments of the present disclosure relate to a vehicle, an apparatus, a computer program, a data carrier, an electronic control unit (ECU), a method for manufacturing an ECU, and a method for testing an ECU. The method for testing an ECU comprises obtaining information on an operational design domain (ODD), obtaining a test scenario space based on the ODD, and testing the ECU for the obtained test scenario space.

## Description

Embodiments of the present disclosure relate to a vehicle, an apparatus, a computer program, a data carrier, an electronic control unit (ECU), a method for manufacturing an ECU, and a method for testing an ECU.

Testing ECUs (Electronic Control Units) before series production is essential to ensure their reliability, functionality, and safety in real-world conditions. These tests help identify and fix software and hardware issues, ensuring that the ECU performs as expected in various scenarios, including extreme temperatures, vibrations, and electrical interference. By testing early, manufacturers can avoid costly recalls, improve product quality, and meet regulatory standards. It also ensures that the ECU integrates well with other vehicle systems, enhancing overall performance and reducing the risk of malfunction.

However, such tests may be expensive, cumbersome, too late because of delayed access. This may result in higher costs and a delay in production. Also, problems may show up late and may be hard to reproduce as the driving behavior of a vehicle may be unique per driving cycle.

Still, vehicle/ECU testing may stay mandatory due to regulations and customer expectations.

Testing on bench level (HIL = hardware in the loop, SIL = software in the loop) may be less expensive, accessible, scalable, and provide fast results (shift left early testing). However, they may fail to reproduce the dynamic behavior of vehicles. Some problems are not found on SIL/HIL front up and show up too often only in the vehicle. So, such tests have limited value. Also, test models may be missing or insufficient

Hence, there may be a demand for an improved concept for testing an ECU.

This demand may be satisfied by the subject matter of the appended independent claims. Optional embodiments are disclosed by the appended dependent claims.

Embodiments are based on the following thoughts:

### Starting point:

- "Cross-ECU" problems do not show up on bench tests with individual ECUs, but when the ECU is put in the vehicle (Gesamtverbund-test)
- "Single-ECU" problems cannot easily be reproduced on the ECU level test bench in many cases.

### Assumption: what is different?

- The interaction of the ECUs in a vehicle is different than it was tested before on isolated ECUs.
- The environment is different (board net (networking, cables, supply), environmental conditions (temp, humidity, rattle, ...)

### Hypothesis:

- interaction of the ECUs mainly on communication level has a significant influence.
- real world is influencing the behavior of the ECUs itself, (timing, orders, ..., may be differently than on the bench).
- environmental conditions (temp, ...) left out of scope (known influences shall be modeled somehow, e.g., core speed reduction because of temp)

### Approach: reduce complexity.

- Find a way to isolate a single ECU - and set up for testing, but get as close as possible - as in the real vehicle

### Hypothesis: Testing on ECU level is not sufficient.

- Testing on ECU level does not (or insufficiently) cover the situation and use cases in the vehicle.
- The interaction of an ECU within the vehicle is not good enough understood and not good enough reflected in testing.
- The common way of defining test cases for ECU level testing is not sufficient (anymore).

### Challenge & basic question:

- How to improve bench test on (v)ECU level to come closer to the in-vehicle situation?
- How to make the found solution more general to use it as a base for pre-tests of a single (v)ECU to offload vehicle tests?

### Steps:

- Start on a single ECU level: Find a method to treat a single (v)ECU on a bench as close as possible to the real vehicle situation. It doesn't matter whether ECU or vECU is used. The approach is the same.
- Generalize the solution for realistic "vehicle like" for a single (v)ECUpretest before actual vehicle tests, even when the vehicle is not yet available.

One idea of the present disclosure is, therefore, to refine a test scenario space based on an operational design domain (ODD) of the ECU. ODD can be understood as a set of operating conditions, including relevant entities, in which a given system, or feature thereof, is specifically designed to function (generalized from SAE J3016). The description of a specific operating environment is referred to as "Operational

Design Domain (ODD)". This ODD contains important operating conditions for the dependable execution of a function or system. These can include, for example, the presence or absence of certain objects, as well as system restrictions, other factors or special environmental conditions. ODD may be used for the design of autonomous (driving) systems.

Embodiments of the present disclosure provide a method for testing at least one real or virtual version of an electronic control unit, ECU, for a vehicle. The method comprises obtaining information on an operational design domain (ODD), obtaining a test scenario space based on the ODD, and testing the ECU for the obtained test scenario space.

This enables systematic and scenario-relevant testing of ECUs by leveraging ODDs, ensuring that tests reflect real-world operating conditions and reducing irrelevant or redundant test cases.

In practice, testing the ECU for the obtained test scenario space may comprise refining a constraint-based test stimuli generation model based on the test scenario space, obtaining test scenarios using the refined constraint-based test stimuli generation model, and testing the ECU for the test scenarios.

This may enhance test precision by refining the constraint-based model using ODD-derived scenarios, leading to more targeted and effective fault detection.

Optionally, the test scenarios are obtained using artificial intelligence.

This may improve test coverage and reduce manual effort in identifying test cases.

In some embodiments, the method further includes obtaining further test scenarios using a non-refined constraint-based test stimuli generation model, and testing the ECU comprises testing the ECU based on the test scenarios from the refined and non-refined constraint-based test stimuli generation model.

This combines refined and general test models to ensure both broad and focused testing, increasing the likelihood of uncovering both common and rare faults.

In some embodiments, the method further includes obtaining further test scenarios based on a user input, and testing the ECU comprises testing the ECU based on the test scenarios from the user input and from the refined and constraint-based test stimuli generation model.

Such embodiments allow expert input to complement automated test generation, enabling domain-specific knowledge to guide testing and improve relevance. Optionally, the method further comprises, if the ECU failed the test, extracting test scenarios which caused the ECU to fail the test and obtaining the test scenarios based on the extracted test scenarios which caused the ECU to fail the test.

That introduces a feedback loop from failed tests to refine future test scenarios, improving test efficiency and accelerating fault isolation and resolution.

In practice, the information on the ODD may comprise information on expected operating conditions under which the ECU is used.

Optionally, the method further comprises in case of a virtual version of the ECU, obtaining a test result from testing the ECU, adapting the virtual version of the ECU based on the test result, and providing the adapted virtual version of the ECU for manufacturing the ECU.

That supports (iterative) improvement of virtual ECUs before physical manufacturing, reducing development costs and enabling early validation. In particular, this may prevent from failures of ECUs in the real-world. For safety-critical ECU functions, this may improve an overall safety of a vehicle where the ECU is to be deployed.

Further embodiments provide a computer program comprising instructions which, when the computer program is executed by a computer, cause the computer to carry out an embodiment of the proposed method.

In some embodiments, the proposed method may be a computer-implemented method where all steps of the proposed method may be executed by a computer or any other kind of programmable hardware.

Further embodiments provide a computer-readable data carrier having stored thereon the proposed computer program.

Still further embodiments provide an apparatus comprising one or more interfaces for communication and a data processing circuit configured to execute an embodiment of the proposed method.

Other embodiments provide a method for manufacturing an ECU. The method comprises applying the method of any one of the claims 1 to 7 to obtain a test result from testing the ECU and manufacturing or designing another ECU based on the test result.

Further embodiments provide an ECU obtainable by an embodiment of the proposed method for manufacturing an ECU.

Still further embodiments provide a vehicle comprising an embodiment of the proposed ECU.

Further, embodiments are now described with reference to the attached drawings. It should be noted that the embodiments illustrated by the referenced drawings show merely optional embodiments as an example and that the scope of the present disclosure is by no means limited to the embodiments presented:

### Brief description of the drawings

Fig. 1 schematically illustrates an embodiment of a method for testing at least one real or virtual version of an ECU for a vehicle;
Fig. 2 schematically illustrates how a coverage of relevant ODD depends on executed scenarios and if those are passed or failed;
Fig. 3 illustrates an exemplary ODD taxonomy;
Fig. 4 shows a flow chart schematically illustrating another embodiment of the proposed approach;
Fig. 5 shows a flow chart schematically illustrating an embodiment of a method for manufacturing an ECU; and
Fig. 6 shows a block diagram schematically illustrating an apparatus according to the proposed approach.

It should be understood that various modifications and variations may be made without departing from the scope of the present disclosure. Accordingly, the detailed description and specific examples provided herein are intended to be illustrative rather than limiting. Where appropriate, features of different embodiments may be combined or substituted to form further embodiments. The figures and examples are not necessarily drawn to scale, and like numerals in different figures may refer to similar elements. It is to be noted that the present disclosure can be practiced in the absence of any element not specifically disclosed herein, unless otherwise indicated.

The problem of an infinite test scenario space in ECU testing arises from the vast number of potential combinations of inputs, environmental conditions, and system states that an ECU may encounter in real-world use. Since ECUs interact with multiple components and external factors like temperature, voltage fluctuations, and driver behavior, the number of possible scenarios becomes unmanageable. It is difficult if not impossible to test every combination, leading to a challenge in ensuring complete coverage. Engineers must prioritize and select the most critical test cases, but even with this approach, there is always a risk that an untested or unexpected scenario could cause the ECU to malfunction in the field.

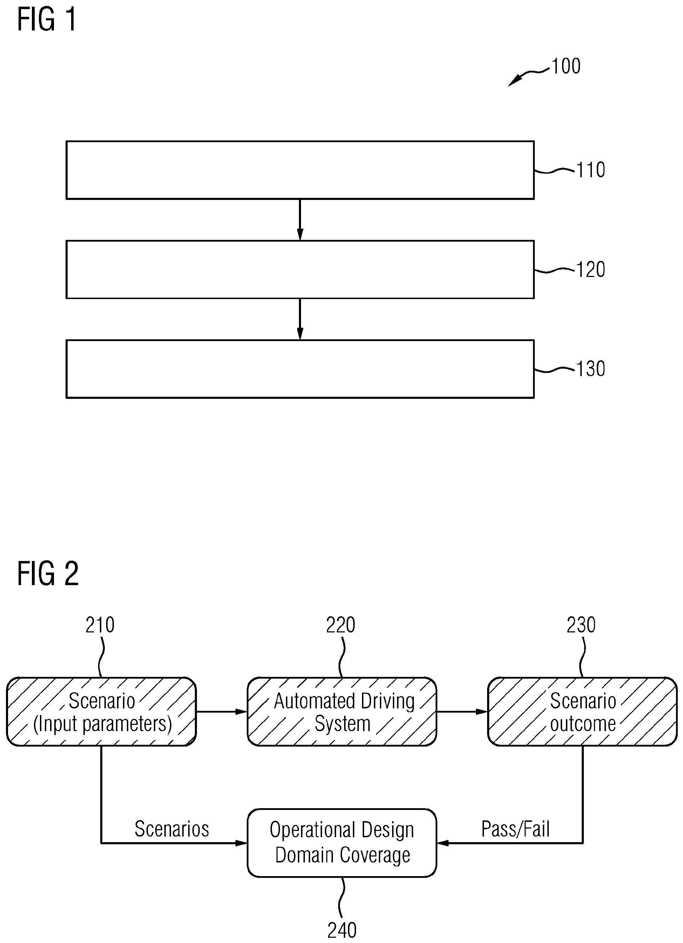

The present approach provides an ODD-driven solution to reduce the infinite test scenario space to likely and relevant test scenarios for a favorable trade-off between coverage and test efficiency. The proposed solution particularly relates to a method for testing at least one real or virtual version of an ECU for a vehicle. Further details of such method are now described below with reference to Fig. 1.

Fig. 1 schematically illustrates an embodiment of a method 100 for testing at least one real or virtual version of an ECU for a vehicle.

In the context of a patent application, a vehicle can be broadly defined as any machine or device for moving, transporting people, goods, or equipment from one location to another. This includes both land-based and non-land-based transport systems and may encompass vehicles with varying levels of automation or autonomy.

Examples of vehicles include, but are not limited to, passenger cars, trucks, buses, motorcycles, agricultural machinery such as tractors, construction equipment like excavators and loaders, rail vehicles such as trains and trams, aerial vehicles including drones and airplanes, and marine vessels like ships and submarines. In the context of electronic control unit (ECU) testing, the term "vehicle" may also extend to simulated or virtual representations of such machines used in development and validation environments.

An Electronic Control Unit (ECU) is broadly defined as an embedded system within a vehicle that controls one or more electrical systems or subsystems based on input data, programmed logic, and communication with other vehicle components. ECUs are typically implemented as microcontroller-based computing units that execute software to perform control, monitoring, and diagnostic functions.

In modern vehicles, ECUs are responsible for a wide range of functionalities, including but not limited to engine management, transmission control, braking systems (ABS/ESC), airbag deployment, infotainment, climate control, driver assistance systems (ADAS), and autonomous driving features. ECUs may operate independently or in coordination with other ECUs via in-vehicle networks such as CAN, LIN, FlexRay, or Ethernet.

The term ECU, as used in this context, encompasses both physical ECUs (hardware units installed in vehicles) and virtual ECUs (vECUs), which are software-based representations used in simulation environments for development, testing, and validation purposes.

An exemplary (real) ECU architecture may include a data processing circuit or processor for processing data and executing control algorithms. The ECU may have input interfaces for receiving signals from sensors and other vehicle systems, such as temperature, pressure, or speed sensors. It also features output interfaces for controlling actuators like motors or valves. Memory components, such as RAM and flash, may be included for storing software, real-time data, and calibration values. Exemplary ECUs may be connected to a vehicle communication network, such as CAN or LIN, to exchange data with other systems.

A virtual version of an ECU, also referred to as "virtual ECU", may be established through software-based simulation. So, the virtual ECU may be understood as a digital model of the ECU's hardware, including, e.g., processors, memory, and interfaces. The ECU's software, such as control algorithms and operating systems, may be then deployed on this virtual platform. Sensor inputs, actuator outputs, and communication protocols like CAN are emulated, allowing the virtual ECU to interact with a simulated vehicle environment. This setup enables testing and validation of the ECU's performance in a controlled, cost-effective manner without needing physical hardware, making it easier to detect and resolve issues early in development.

The proposed method comprises obtaining 110 information on an ODD (of/for the ECU). The ODD for an ECU may be derived by analyzing specific tasks the ECU is designed to perform and an environment in which it will operate. This may involve understanding the vehicle's intended usage, such as urban, highway, or off-road driving, and identifying factors like road conditions, weather, geographical circumstances, typical daytime of operation, lighting, and traffic patterns. As well, safety and regulatory requirements may define the ODD.

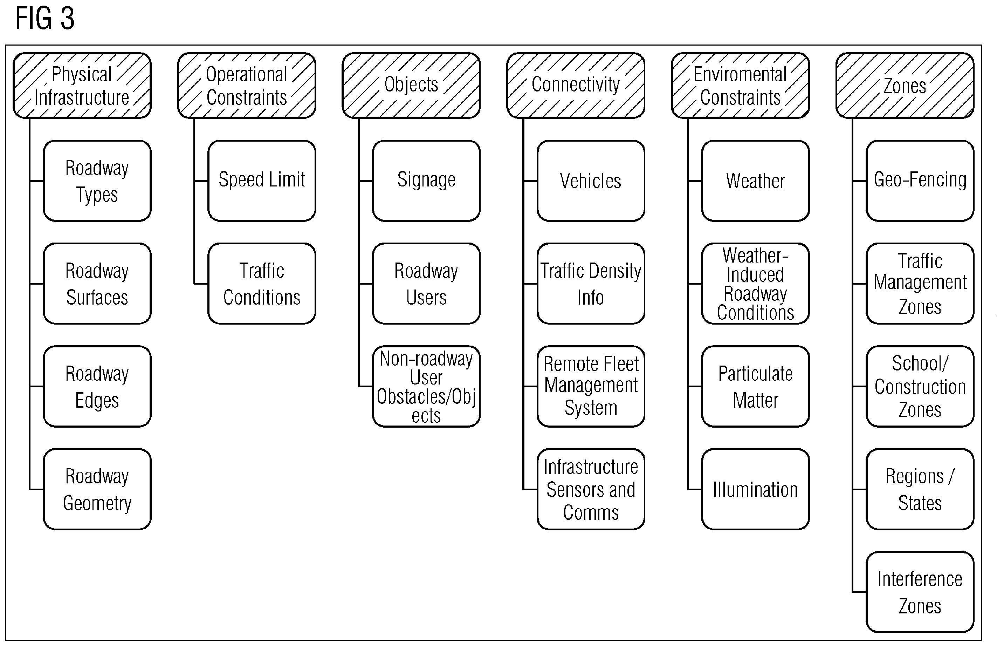

In the automotive industry, ODDs define the operating conditions under which a vehicle's automated driving systems can be safely engaged. Each ODD is specific to the vehicle model and the feature. Within a single vehicle brand, models have varying levels of automated driving capabilities and will therefore have different ODDs. Some commonly cited ODD criteria include road features, time of day, weather and terrain. For example, a hands-free driving feature might be designed to operate during the day but not at night, on a clear day but not in heavy rain or fog, or on a relatively straight stretch of highway but not in a confined urban setting. Fig. 3 shows exemplary categories of the ODD, here as defined by the National Highway Traffic Safety Administration (NHTSA) for its ODD taxonomy to organize and identify various ODDs.

This list is not exhaustive, however, and many more categories might also be used to define an ODD as mentioned above.

In the context of ECU testing, this ODD information is used to derive a relevant test scenario space that reflects realistic and critical operating conditions. For instance, an ECU responsible for adaptive cruise control might have an ODD that includes highway driving during daylight with moderate traffic, while excluding urban environments or poor weather conditions. Similarly, a lane-keeping assist ECU might be tested under scenarios involving curved roads, lane markings of varying visibility, and different lighting conditions.

The information on the ODD may be obtained through a combination of analytical, empirical, and data-driven methods. One approach involves analyzing the intended function of the ECU and identifying the environmental and operational conditions under which it is expected to perform reliably. This includes examining parameters such as road types, traffic conditions, weather, lighting, and the presence of other road users or obstacles. These parameters can be derived from system specifications, regulatory requirements, or safety standards.

Additionally, ODD information can be extracted from real-world driving data collected from test vehicles or fleets. This data may include sensor readings, communication logs, and behavioral patterns observed during operation. By processing and clustering this data, representative scenarios and boundary conditions can be identified and formalized into ODD definitions.

Another method involves simulation-based exploration, where virtual environments are used to model and evaluate a behavior of the vehicle under a wide range of conditions. This allows for the systematic identification of relevant ODD parameters, especially in early development phases when real-world data may be limited.

Furthermore, the information on the ODD may be obtained from expert/user input. This is based on the finding that domain knowledge may play a critical role in defining ODDs, particularly for edge cases or rare conditions that may not be well represented in empirical data. Over time, the ODD definitions can be refined and expanded based on feedback from testing, validation, and field performance.

Further, the proposed method comprises obtaining 120 a test scenario space based on the ODD. For this, regions of the test scenario space which are unlikely or not expected in consideration of the ODD may be excluded from the test scenario space. Vice versa, regions of the test scenario space which are typical or likely in view of the ODD may be included/selected for testing.

Generally, the test scenario space may be obtained by systematically translating the defined operating conditions of the ODD into a structured set of testable situations that reflect the real-world contexts in which the ECU is expected to function. This process begins with the identification and formalization of relevant ODD parameters, such as road types, weather conditions, traffic patterns, and time-of-day constraints. These parameters define the boundaries and variability of the operational environment.

Once the ODD is defined, the next step involves generating combinations of these parameters to form a multidimensional space of possible scenarios. However, because the number of theoretical combinations can be extremely large, the scenario space is typically constrained using constraint-based testing (CBT) techniques. These techniques apply logical and functional constraints to eliminate irrelevant or infeasible combinations, focusing instead on those that are most likely to reveal faults or represent critical use cases.

In some implementations, artificial intelligence or machine learning methods may be used to analyze historical data, simulation results, or expert knowledge to prioritize or cluster scenarios within the ODD. This helps in identifying representative, edge-case, or high-risk scenarios that should be included in the test space.

The resulting test scenario space is therefore a curated subset of all possible operating conditions defined by the ODD, tailored to the specific function and context of the ECU under test. It serves as the foundation for generating test vectors, modeling test environments, and executing validation procedures on real or virtual ECUs.

The test scenario space may take the form of structured data that represents a wide range of operating conditions and their combinations. This data may be organized in a tabular or model-based format, where each row or entry corresponds to a specific test scenario, and each column represents a parameter or constraint defined by the ODD.

The content of this data may include environmental variables such as weather (e.g., clear, rain, snow), lighting conditions (e.g., day, night, dusk), road types (e.g., highway, urban, rural), traffic density (e.g., low, medium, high), and dynamic elements like the presence of pedestrians, cyclists, or other vehicles. It may also include system-level parameters such as vehicle speed, acceleration, braking behavior, sensor availability, and communication latency between ECUs.

Each scenario in the space is defined by a unique combination of these parameters, and may be annotated with metadata such as scenario ID, priority level, expected outcome, and relevance to specific ECU functions. In more advanced implementations, the scenario space may be represented as a graph or tree structure, where nodes represent states or conditions and edges represent transitions or interactions.

This structured representation allows automated tools to generate test vectors, simulate behavior, and evaluate ECU performance under controlled yet realistic conditions. It also supports traceability, enabling developers to link test results back to specific ODD conditions and refine the scenario space over time based on observed outcomes.

Further, the proposed method 100 includes testing 130 the ECU for the obtained test scenario space.

Testing the ECU may comprise executing simulations or real-time tests in which the ECU is exposed to the specific conditions defined by each scenario. This process may include configuring a test environment - either a virtual platform (vECU) or a hardware-in-the-loop (HIL) setup - that can accurately emulate the operational context described in the scenario data. The test environment is programmed to reproduce the relevant inputs, such as sensor signals, communication messages, and environmental parameters, in accordance with the scenario definitions.

During the test, the ECU operates as it would in a real vehicle, processing the inputs and generating outputs based on its embedded software and control logic. These outputs are monitored and compared against expected behaviors or safety requirements to determine whether the ECU performs correctly under the given conditions. That is, the ECU's behavior during the testing may be compared to expected behavior to determine, e.g., whether it functions appropriately and/or meets safety requirements. Any deviations, failures, or unexpected behaviors may be logged for further analysis.

In some cases, the testing procedure may be automated using test orchestration tools that can iterate through large sets of scenarios, apply constraints, and adapt the test flow based on intermediate results. Feedback from failed scenarios may be used to refine the test space or adjust the ECU model, especially in virtual testing environments. This iterative process helps to identify edge cases, validate robustness, and ensure that the ECU meets functional and safety requirements across the full range of its intended operational domain.

The larger the test scenario space, the more computing resources may be required for the test. Hence, the test scenario space may be reduced. For reducing the test scenario space, a constraint-based test stimuli generation model may be refined based on the test scenario space (reduced based on the ODD).

A constraint-based test stimuli generation model for ECU testing may be configured for constrained-based testing (CBT) (as mentioned above). The general idea beneath this testing paradigm is to exploit constraint solving and optimization to generate test cases for testing a system, so that the fault-revealing capabilities of the testing process can be improved. Static analysis aims at finding runtime errors (e.g., division-by-zero, overflows, ...) at compilation time. CBT aims at finding functional faults.

So, in context of the present disclosure the constraint-based test stimuli generation model may be configured to create test inputs for testing the ECU by applying specific rules or constraints that reflect real-world operating conditions. Constraints may define valid ranges for variables such as sensor inputs (e.g., realistic sensor data), system states (vehicle ignition on/off, cruise control active/inactive, brake system engaged/released, gear position, and/or the like), and environmental factors (e.g., weather conditions, light conditions, and/or the like), ensuring the generated stimuli are both realistic and diverse. According to embodiments of the proposed approach, the constraint-based test stimuli generation model may create inputs for the ECU within the (reduced) test scenario space. In doing so, the constraint-based test stimuli generation model obtains test scenarios. Then, the ECU may be tested for the test scenarios obtained by the constraint-based test stimuli generation model.

As the skilled person will understand, the test scenarios may be obtained using an appropriate artificial intelligence.

So, to summarize a general idea of the proposed concept is to describe an operation space in which the ECU shall operate, which opens a large space of variations that lead into specific scenarios, where a test is executed, and which leads to a specific communication behavior between the different ECUs. This allows early tracking of the test space that was executed. Also, it enables to virtually vary certain parameters that lead to different communication behavior. With that the test width is significantly increased and late failed system integration tests can be identified at a very early stage. Additionally, by keeping track of the operation space and the test results achieved one can identify system weaknesses that occur regularly under certain conditions and refine system requirements in that space.

Fig. 2 schematically illustrates how test scenarios may be obtained and tested.

As can be seen, in a first step 210, scenario information (input parameters) may be determined. In a next step 220, they are applied for a specific automated driving system (ADS) to obtain a scenario outcome (see step 230). The scenario outcome refers to the result of executing a test scenario within the defined ODD (here: the specific ADS). The scenario outcome can be one of the following:
Passed: The ADS behaved as expected under the scenario conditions.
Failed: The ADS did not meet expected behavior or safety requirements.

These outcomes help assess test coverage in step 240 and guide refinement of test scenarios and ECU design.

What is described in connection with an ADS, here, can be analogously applied for any other kind of system, e.g., any kind of ECU or ECU system in a vehicle.

Fig. 3 illustrates an exemplary ODD taxonomy.

As can be seen, the information on the ODD may include information on different ODD categories, for example, on a physical infrastructure, operational constraints, objects, connectivity, environmental conditions, and/or zones. The information on the physical infrastructure may include information on roadway types, roadway surfaces, roadway edges, and/or a roadway geometry. The information on the operational constraints may include information on a speed limit and/or traffic conditions. The information on the objects (in an environment of the vehicle) may include information on signage (traffic signs), roadway users (e.g., types of traffic participants), and/or non-roadway users, obstacles, and/or other objects. The information on the connectivity may include information on vehicles (e.g., connectivity requirements, and/or information on a need for V2X communication, or further services), traffic density, remote fleet management systems, infrastructure sensors and available communication technology. The information on the environmental conditions may include information on the weather, weather-induced roadway conditions (e.g., slippery, dry, etc.), particulate matter, and illumination/light conditions. The information on zones may include information on geo-fencing, traffic management zones, school zones, construction zones, regions/states, and/or interference zones.

It is noted that the list of ODD information categories and types of information is not limited to the above taxonomy but may include other or further information.

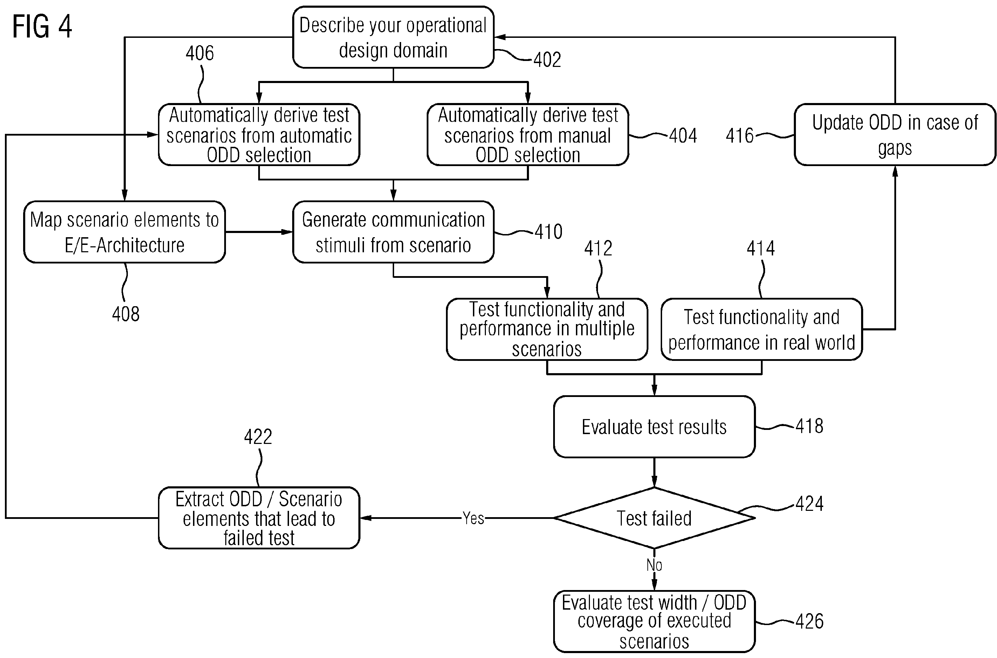

Fig. 4 shows a flow chart schematically illustrating another embodiment of the proposed approach.

In particular, Fig. 4 shows a procedure including the proposed approach.

As can be seen, in a first step 402, the information on the ODD is obtained 402.

Then, a test scenario space, e.g., a set of test scenarios, is determined based on the ODD - automatically (see step 406) and/or manually (see step 404).

In the automatic approach (step 406), software tools - often using constraint-based testing models and/or artificial intelligence - analyze the ODD parameters such as road types, weather, traffic, and time of day. These tools generate combinations of these parameters that are likely to occur in real-world operation or are critical for safety. Further, a constraint-based test stimuli generation model may be refined based on the test scenario space obtaining test scenarios using the refined constraint-based test stimuli generation model.

Constraints are applied to eliminate unrealistic or irrelevant combinations, and the resulting scenarios are structured into a test scenario space. This process can also incorporate historical data, simulation results, or machine learning models to prioritize or cluster scenarios.

The constraint-based test stimuli generation model may be a software-based mechanism that generates test inputs (stimuli) for the ECU. It does so by applying logical constraints that reflect real-world operating conditions. These constraints define valid ranges, relationships, and dependencies between variables such as speed, weather, road type, sensor inputs, and system states. For example, a constraint might specify that a lane-keeping assist function should only be active when the vehicle is traveling above 60 km/h on a road with visible lane markings.

Refining this model may include tailoring it to the specific test scenario space derived from the ODD. The test scenario space includes only those scenarios that are relevant to the ECU's intended operational environment. For instance, if the ECU is designed for urban driving, the refined model would exclude highway or off-road conditions. This refinement ensures that the generated test scenarios are not only valid but also meaningful and efficient, avoiding irrelevant combinations.

Once refined, the model is used to generate test scenarios. These can be concrete instances of operating conditions, such as "urban road, night, light rain, moderate traffic, speed 40 km/h," which are then used to simulate the ECU's behavior.

The ECU is, then, tested using these scenarios, either in a virtual environment (vECU) or on a hardware-in-the-loop (HIL) setup.

Optionally, two different constraint-based test stimuli generation models may be used, for example, one that is refined based on the ODD and one that is not. The purpose of this is to combine the strengths of both targeted and broad testing strategies.

The refined model is tailored to the specific test scenario space derived from the ODD. It focuses on generating test scenarios that are highly relevant to the ECU's intended operational environment. For example, if the ECU is designed for use in urban driving, the refined model would prioritize scenarios involving stop-and-go traffic, pedestrian crossings, and traffic lights.

The non-refined model, on the other hand, is more general. It generates test scenarios without filtering them through the ODD constraints. This allows for broader coverage, including edge cases or unexpected combinations of conditions that might not be explicitly defined in the ODD but could still occur in practice.

By using both models, the ECU may be tested not only under expected and likely conditions but also under less predictable or rare situations. This dual approach increases the robustness of the testing process and helps uncover faults that might otherwise be missed.

Optionally, the test scenarios are obtained using artificial intelligence (AI). Test scenarios may be obtained from the ODD using AI by analyzing the information on the ODD and transforming it into concrete, testable situations. AI models, particularly those based on machine learning, can process large volumes of driving data, sensor logs, and environmental parameters to identify patterns and correlations that represent realistic and critical operating conditions.

For example, AI can cluster similar driving situations based on ODD parameters such as road type, weather, traffic density, and time of day. These clusters can then be used to define representative test scenarios that are both diverse and relevant.

In the manual approach (step 404), a user defines test scenarios by specifying the ODD based on their experience and system knowledge. In this way, further test scenarios can be obtained based on a user input. For this, a user may select specific combinations of ODD parameters, e.g., indicative of test scenarios which are known to be critical, problematic, or representative of typical use cases and provide corresponding user input indicative of such test scenarios. Manual input is especially valuable for edge cases or rare conditions that automated tools might overlook or misclassify.

Both approaches, the automatic and manual approach can be used in combination to ensure that the test scenario space is both comprehensive and relevant, balancing automation efficiency with expert insight.

Further, scenario elements, e.g., specific elements of a test scenario - such as sensor inputs, environmental conditions, or vehicle behaviors - are mapped to the corresponding components and communication paths within the vehicle's electrical/electronic (E/E) architecture (see step 408).

This may include identifying which ECUs, sensors, actuators, and network interfaces are involved in handling or responding to a given scenario. For example, if a scenario involves detecting a pedestrian at night in rainy conditions, this would be mapped to the camera ECU, the lighting control ECU, and possibly the braking system ECU, along with the communication buses that connect them.

By performing this mapping, the test system can simulate or stimulate the correct parts of the architecture, ensuring that the scenario is realistically and effectively tested at the ECU level.

In a further step 410, the (abstract) test scenarios - defined by ODD parameters - are converted into concrete, time-sequenced data that mimics the communication behavior of a vehicle's electronic systems.

A further step 412 includes testing the functionality and performance of the system under test, e.g., an ECU, for the test scenarios.

This may include determining a behavior of the ECU for the test scenarios.

In practice, this may include taking the test scenarios (such as highway driving in rain with moderate traffic) and determining what messages would be exchanged between ECUs under those conditions. These messages might include sensor readings, control commands, or status updates transmitted over in-vehicle networks like CAN or Ethernet. The generated stimuli are then used to simulate real-world communication patterns in a test environment, allowing the ECU under test to react as it would in an actual vehicle.

Likewise, the ECU may be tested and validated in the real world, e.g., in field trials (see step 414). Real world observations may be used to identify gaps in the information on the ODD compared to the real world and, if so, the ODD information may be updated to fill the gaps (e.g., by adding ODD information corresponding to real world observations and missing in the information on the ODD).

In a next step 418, results of the test are evaluated.

This may include analyzing outcomes of the ECU tests conducted across the test scenarios. This may involve comparing the ECU's actual behavior for the test scenarios with expected behavior defined by functional requirements, safety criteria, or performance benchmarks.

If the ECU behaves correctly and meets all criteria, the scenario is marked as passed (see alternative "no", step 424). In this case, the ECU may be considered functioning properly. Optionally, the coverage (see Fig. 2) may be evaluated (see step 426) in that case to check a validity or reliability of the result.

If deviations, errors, or failures occur, the scenario is marked as failed (see alternative "yes", step 424) and specific conditions ("scenario elements") or test scenarios that led to the failure may be extracted from the information on the ODD (see step 422). In practice, test scenarios may be iteratively extended, adapted, and/or refined. In such embodiments, a feedback loop may be used to obtain or determine test scenarios based on the extracted test scenarios which caused the ECU to fail the test. For example, more test scenarios may be obtained which are similar (i.e., their deviation is less than a predefined threshold) to the test scenarios which led to failures. In case of failures, the ECU may be adapted accordingly based on the result of the test. In practice, the proposed approach may be applied iteratively until the ECU is functioning properly (i.e., as expected).

The proposed approach may be particularly applied for testing and improving virtual ECUs. The resulting virtual ECU may be then used as basis for manufacturing a real/physical ECU.

More specifically, a test result from testing the virtual ECU and the virtual version of the ECU may be adapted based on the test result. The adapted virtual ECU is then for manufacturing the ECU.

For example, the results from the tests-such as how the ECU responds to specific inputs, how it communicates with other systems, and whether it meets performance and safety requirements-provide valuable insights into the ECU's design and behavior.

These results can be used to adapt or refine the virtual ECU model. For example, if the virtual ECU fails to respond correctly to a certain scenario, developers can adjust the control algorithms, timing parameters, or communication protocols within the virtual model. Once the virtual ECU performs reliably across the defined test scenarios, it serves as a validated reference for manufacturing.

In manufacturing, the adapted virtual ECU can be used to generate the production software that will be flashed onto the physical ECU hardware. It may also inform hardware configuration decisions, such as processor selection or memory sizing, based on the performance observed during virtual testing.

One idea of testing virtual ECUs is to create a feedback loop between simulation and production. When a virtual ECU is tested using the scenarios derived from the ODD, its behavior is evaluated. If the test reveals issues - such as incorrect responses, timing problems, or integration faults - the virtual ECU can be modified accordingly. These modifications might involve changes to the software logic, calibration parameters, or communication behavior.

Once the virtual ECU performs correctly under the defined test scenarios, it serves as a validated reference for manufacturing the real ECU. This approach reduces the risk of errors in the final product, shortens development cycles, and lowers costs by catching problems early in the virtual phase. It also supports iterative development, where the ECU design evolves through repeated testing and refinement before any hardware is produced. This is particularly valuable for safety-critical systems, where early validation can significantly improve reliability, compliance with regulatory standards, and/or the safety in applications of the ECU.

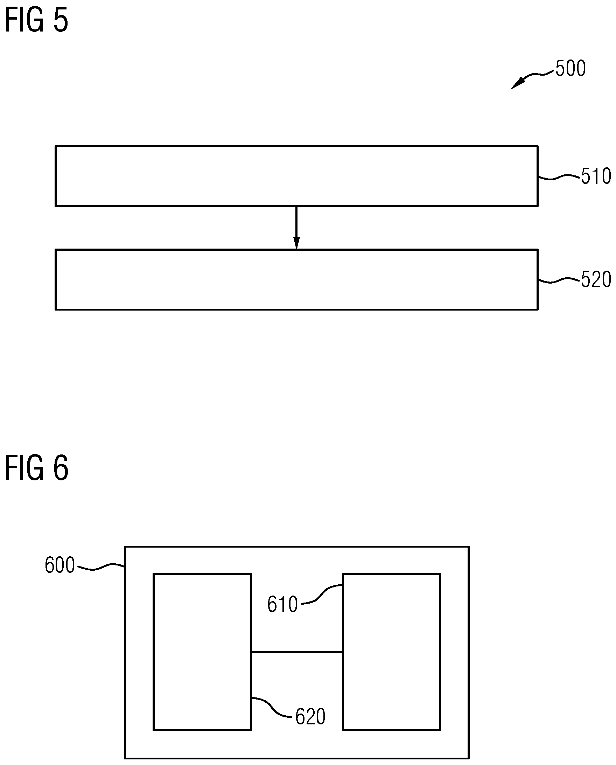

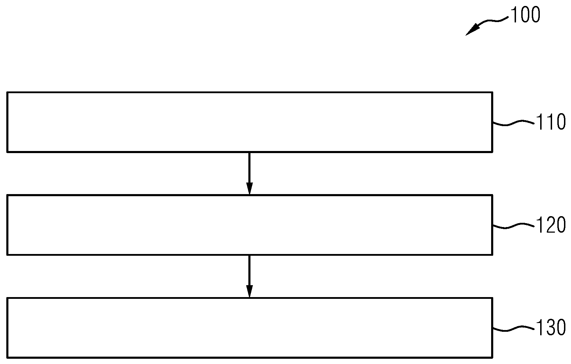

Fig. 5 shows a flow chart schematically illustrating an embodiment of a method 500 for manufacturing an ECU.

As per embodiments of method 500, an embodiment of the proposed method for testing at least one real or virtual version of an ECU is applied (see step 510) to obtain a test result from testing the ECU and another ECU is manufactured or designed (step 520) based on the test result, as laid out above.

The proposed approach for ODD-driven testing is not limited to any specific type of ECU. Rather, it is designed to be broadly applicable across a wide range of ECUs used in various vehicle systems. This includes, for example, ECUs responsible for powertrain control, braking systems, steering, infotainment, battery management, climate control, and advanced driver assistance systems (ADAS). It may also be applied to ECUs involved in autonomous driving functions, lighting control, or chassis dynamics. The method is adaptable to both safety-critical and non-safety-critical ECUs, and it supports testing in both virtual and physical environments. This flexibility ensures that the approach can be integrated into diverse development workflows across different vehicle domains and levels of automation.

As a skilled person will understand, the proposed testing method may be implemented in an apparatus.

Fig. 6 shows a block diagram schematically illustrating an embodiment of such an apparatus 600. The apparatus comprises one or more interfaces 610 for communication and a data processing circuit 620 configured to execute the proposed method.

In embodiments, the one or more interfaces 610 may comprise wired and/or wireless interfaces for transmitting and/or receiving communication signals in connection with the execution of the proposed concept. In practice, the interfaces, e.g., comprise pins, wires, antennas, and/or the like. As well, the interfaces may comprise means for (analog and/or digital) signal or data processing in connection with the communication, e.g., filters, samples, analog-to-digital converters, signal acquisition and/or reconstruction means as well as signal amplifiers, compressors and/or any encryption/decryption means.

The data processing circuit 620 may correspond to or comprise any type of programmable hardware. So, examples of the data processing circuit 620, e.g., comprise a memory, microcontroller, field programmable gate arrays, one or more central, and/or graphical processing units. To execute the proposed method, the data processing circuit 620 may be configured to access or retrieve an appropriate computer program for the execution of the proposed method from a memory of the data processing circuit 620 or a separate memory which is communicatively coupled to the data processing circuit 620.

It should be understood that various modifications and variations may be made without departing from the scope of the present disclosure. Accordingly, the detailed description and specific examples provided herein are intended to be illustrative rather than limiting. Where appropriate, features of different embodiments may be combined or substituted to form further embodiments. The figures and examples are not necessarily drawn to scale, and like numerals in different figures may refer to similar elements. It is to be noted that the present disclosure can be practiced in the absence of any element not specifically disclosed herein, unless otherwise indicated.

## Claims

1. A method for testing at least one real or virtual version of an electronic control unit, ECU, for a vehicle, the method comprising:
obtaining information on an operational design domain, ODD;
obtaining a test scenario space based on the ODD; and
testing the ECU for the obtained test scenario space.

2. The method of claim 1, wherein testing the ECU for the obtained test scenario space comprises:
refining a constraint-based test stimuli generation model based on the test scenario space;
obtaining test scenarios using the refined constraint-based test stimuli generation model; and
testing the ECU for the test scenarios.

3. The method of claim 2, wherein the test scenarios are obtained using artificial intelligence.

4. The method of claim 2 or 3, wherein the method further includes obtaining further test scenarios using a non-refined constraint-based test stimuli generation model, and wherein testing the ECU comprises testing the ECU based on the test scenarios from the refined and non-refined constraint-based test stimuli generation model.

5. The method of any one of the claims 2 to 4, wherein the method further includes obtaining further test scenarios based on a user input, and wherein testing the ECU comprises testing the ECU based on the test scenarios from the user input and from the refined constraint-based test stimuli generation model.

6. The method of any one of the claims 2 to 5, wherein the method further comprises:
if the ECU failed the test, extracting test scenarios which caused the ECU to fail the test; and
obtaining the test scenarios based on the extracted test scenarios which caused the ECU to fail the test.

7. The method of any one of the preceding claims, wherein the information on the ODD comprises information on expected operating conditions under which the ECU is used.

8. The method of any one of the preceding claims, wherein the method further comprises:
in case of a virtual version of the ECU, obtaining a test result from testing the ECU, adapting the virtual version of the ECU based on the test result, and providing the adapted virtual version of the ECU for manufacturing the ECU.

9. A computer program comprising instructions which, when the computer program is executed by a computer, cause the computer to carry out the method of any one of the claims 1 to 8.

10. A computer-readable data carrier having stored thereon the computer program of claim 9.

11. An apparatus comprising:
one or more interfaces for communication; and
a data processing circuit configured to execute the method of any one of the claims 1 to 7.

12. A method for manufacturing an ECU, the method comprising:
applying the method of any one of the claims 1 to 7 to obtain a test result from testing the ECU; and
manufacturing or designing another ECU based on the test result.

13. An ECU obtainable by a method of claim 12.

14. A vehicle comprising an ECU according to claim 13.
